# EUROPÄISCHE PATENTSCHRIFT

(11) **EP 1 624 310 B1**
(45) Veröffentlichungstag und Bekanntmachung des Hinweises auf die Patenterteilung: **26.05.2010**
(21) Anmeldenummer: 05016717.0
(22) Anmeldetag: 01.08.2005
(51) Int. Cl.: G01R 11/04

(54) **Leiter- und Klemmenanordnung in einem Stromzähler**
Arrangement with a connecting terminal and a conductor in an electricity meter
Dispositif avec une borne de raccordement et un conducteur dans un compteur d'électricité

(30) Priorität: 06.08.2004 DE 102004038540
(43) Veröffentlichungstag der Anmeldung: 08.02.2006
(73) Patentinhaber: Elster Messtechnik GmbH, 68623 Lampertheim (DE)
(72) Erfinder: Arzberger, Michael, Dr.-Ing., 68259 Mannheim (DE); Lampe, Jochen, Dipl.-Ing., 68259 Mannheim (DE); Schlenker, Wolfgang, 68199 Mannheim (DE)
(74) Vertreter: Miller, Toivo

(56) Entgegenhaltungen:
- WO-A1-99/08119
- CH-A5- 684 215
- GB-A- 2 259 783
- US-A- 5 300 917
- US-A1- 2001 043 062
- US-A1- 2003 001 593
- US-A1- 2003 011 355
- "USING PCB AS A CURRENT SHUNT" ELECTRONICS WORLD, NEXUS MEDIA COMMUNICATIONS, SWANLEY, KENT, GB, Bd. 99, Nr. 1691, 1. Oktober 1993 (1993-10-01), Seiten 862-863, XP000396549 ISSN: 0959-8332

## Beschreibung

Die Erfindung betrifft eine Leiter- und Klemmenanordnung in einem Stromzähler, welcher insbesondere als elektronischer Stromzähler ausgeführt ist, gemäß dem Oberbegriff des Anspruches 1.

Die Verbindung des elektronischen Stromzählers mit dem Stromnetz dient zum einen der Erfüllung der eigentlichen Messaufgabe, der Bestimmung des Leistungs- beziehungsweise Energiebezuges der dem Stromzähler nachgeschalteten Verbraucher, und zum anderen zur Energieversorgung der Zählerelektronik im Stromzähler.

Üblicherweise erfolgt die elektrische Verbindung des Stromzählers mit dem Stromnetz durch geeignete, von der Außenseite des Zählergehäuses zugängliche, Anschlussklemmen.

Die eigentlichen Messgrößen Energie und Leistung werden vom Stromzähler durch eine geeignete Verknüpfung der Messwerte Verbrauchsstrom und Spannung gebildet.

Der Verbraucherstrom kann dabei entweder direkt durch den Stromzähler oder indirekt über einen geeichten Stromtransformator geführt werden. Im folgenden wird der Begriff Verbraucherstrom gleichbedeutend für den tatsächlichen, also direkten Verbraucherstrom, als auch für den durch den Messwandler transformierten Strom benutzt.

Für die Messung wird der Verbraucherstrom von einer Eingangsklemme über ein geeignetes, im Zähler befindliches Messelement zu einer Ausgangsklemme geführt. Für die Stromführung von den Anschlussklemmen zum Messelement des Zählers werden je nach Ausführung und Nennstromstärke des Zählers flexible Leiter, insbesondere Litzen oder Drähte, oder bei einer hohen Nennstromstärke, massive Leiterbügel eingesetzt.

Das Messelement wird vom Messstrom durchflossen und erzeugt eine das Messsignal repräsentierende Ausgangsgröße, die einer Messsignalverarbeitungs- und Anzeigeeinheit zur weiteren Verarbeitung zur Verfügung gestellt wird.

Zusätzlich zur vorgenannten Stromführung für die eigentliche Messaufgabe sind zusätzliche Spannungszuführungen für die Energieversorgung des Stromzählers, beispielsweise mittels eines Netzteiles, vorgesehen. Die Spannungszuführung zwischen den Anschlussklemmen und der Energieversorgungseinheit des Stromzählers erfolgt üblicherweise durch ausreichend isolierte, aber nur sehr begrenzt stromtragfähige Litzen.

Durch die spezifische Anordnung des Zählers in der Versorgungskette stellen sich auch besondere Anforderungen an den Überspannungsschutz, da der Stromzähler das erste Verbrauchsgerät am Übergang des Stromverteilnetzes des Energieversorgers zum Netz des Kunden ist.

Für den Überspannungsschutz sind im Netzteil des Stromzählers üblicherweise Anordnungen zur Überspannungsbegrenzung vorgesehen, welche die Störenergie dissipativ abbauen und im Überspannungsfall zu einer erheblichen Strombelastung oder gar Überlastung der im Nennbetrieb praktisch unbelasteten Spannungszuführung des Zählers führen.

Von Nachteil ist weiterhin, dass die Verwendung der massiven Leiterbügel zur Verbindung der Anschlussklemmen mit den Strommesselementen einen nicht unerheblichen Aufwand bei der Herstellung und Montage des Stromzählers erfordert, da die Leiterbügel einerseits zuverlässig mit den Klemmen zu verbinden sind und andererseits durch das Strommesselement geführt werden müssen.

Auch die Signalführung mit flexiblen Leitern weist eine Reihe von Nachteilen auf, da die Leiter entweder aufwendig im Gehäuse zu fixieren sind oder völlig unkontrolliert im Gehäuse verlaufen, wodurch insbesondere in hochempfindlichen Messwerken Störeinflüsse auf das Messergebnis der Stromzähler nicht zu vermeiden sind.

In der CH 684215 A5 ist ein modular aufgebauter Elektrizitätszähler beschrieben, welcher ein Gehäuseunterteil, zwei Leiterplatten, ein Gehäuseoberteil, ein Zwischenstück und einen Klemmendeckel aufweist. Im Gehäuseunterteil sind Messelemente sowie von der Außenseite des Gehäuseunterteils zugängliche Anschlussklemmen angeordnet.

Eine als Leiterbahn ausgeführte direkte Verbindung zwischen den Anschlussklemmen und zugeordneten Messelementen ohne Zwischenschaltung zusätzlicher Bauteile ist hier nicht vorgesehen. Die elektrischen Verbindungen zwischen den im Gehäuseunterteil befindlichen Messelementen und den Leiterplatten wird über miteinander zusammenwirkende Kontaktstifte und zugeordnete Kontaktfedern gebildet.

Der Erfindung liegt demgemäss die Aufgabe zugrunde, eine neue Leiter- und Klemmenanordnung in einem Stromzähler, insbesondere in einem elektronischen Stromzähler, anzugeben, bei dem die vorgenannten Nachteile, insbesondere zur Vermeidung von Störeinflüssen durch die Leiterführungen zwischen den Anschlussklemmen und den Messelementen sowie die aufwendige Herstellung der Verbindung zwischen den Anschlussklemmen und den Strommesselementen des Stromzählers, überwunden werden.

Diese Aufgabe wird erfindungsgemäß mit den in Anspruch 1 angegebenen Merkmalen gelöst. Vorteilhafte Ausgestaltungen und Verbesserungen der erfindungsgemäßen Leiter- und Klemmenanordnung in einem Stromzähler sind in weiteren Ansprüchen und in der Beschreibung angegeben.

Die erfindungsgemäße Leiter- und Klemmenanordnung in einem Stromzähler, welcher vorzugsweise als elektronischer Stromzähler ausgeführt ist, umfasst in einem Zählergehäuse angeordnete Messelemente sowie eine Messsignalverarbeitungs- und Anzeigeeinheit, wobei das Zählergehäuse zur elektrischen Verbindung des Stromzählers mit dem Stromnetz von der Außenseite des Zählergehäuses zugängliche Anschlussklemmen aufweist und jeweils wenigstens eine elektrische Verbindung als Stromführung von den Anschlussklemmen zu den Messelementen für die Bestimmung des Leistungs- beziehungsweise Energiebezuges der dem Stromzähler nachgeschalteten Verbraucher vorgesehen ist.

Erfindungsgemäß sind neben den Messelementen auch die Anschlussklemmen auf einer Platine angeordnet und vorzugsweise aufgelötet oder eingepresst.

Auch die Leiter, nachfolgend auch als Strom- und Spannungsführung bezeichnet, zwischen den Anschlussklemmen und den Messelementen sowie zwischen den Anschlussklemmen und einer, vorzugsweise als Netzteil ausgeführten, Einheit zur Energieversorgung des Stromzählers, sind auf der Platine aufgebracht.

In einer vorteilhaften Ausgestaltung der Erfindung ist vorgesehen, die Messelemente in die Stromführungen des Stromzählers zu integrieren und somit unter Ausnutzung des spezifischen ohmschen Widerstandes der, vorzugsweise als Leiterbahnen oder gedruckte Schaltungen ausgeführten Stromführungen, die Messung der Stromstärke der dem Stromzähler nachgeschalteten Verbraucher durchzuführen.

Zur Kompensation des durch den Temperaturkoeffizienten des spezifischen Widerstandes der Leiterbahn auftretenden Messfehlers ist in vorteilhafter Weise ein Temperaturmessfühler direkt auf der Leiterbahn zur Stromführung vorgesehen, welcher das den Messfehler charakterisierende Signal einem zur Messsignalverarbeitung und Messfehlerkompensation vorgesehenen Mikrorechner zuführt.

In einer vorteilhaften Weiterbildung der erfindungsgemäßen Anordnung umfasst die Platine wenigstens zwei separate Platinenteile, auf welchen die mit hohen Strömen oder Spannungen beaufschlagten Baugruppen, wie beispielsweise Überspannungsbegrenzer, von den Strommesselementen und der Messsignalverarbeitungs- und Anzeigeeinheit zur Vermeidung von Störeinflüssen getrennt platziert sind.

Dadurch dass die Anschlussklemmen direkt auf der Platine aufgebracht sind und die Stromführungen zwischen den Klemmen und den Messelementen und die Spannungszuführungen, insbesondere zur Spannungsversorgung des Netzteiles, direkt auf der Platine erfolgen, entfällt eine aufwendige Fixierung der Verbindungen zur Strom- und Spannungsführung im Zählergehäuse. Durch eine entsprechende Dimensionierung der Spannungszuführung ist ohne großen Aufwand eine ausreichende Strombelastbarkeit der Spannungszuführung für die Energieversorgungseinheit im Überspannungsfall gewährleistet.

Mit der vorgesehenen Anordnung der Strom- und Spannungselemente, insbesondere der mit hohen Strömen oder Spannungen beaufschlagten Baugruppen getrennt von der Messsignalverarbeitungs- und Anzeigeeinheit, auf einem separaten Platinenteil werden Störeinflüsse auf die Verarbeitung der Messsignale weitgehend vermieden.

Anhand der in den folgenden Figuren dargestellten Ausführungsformen sollen die Erfindung sowie vorteilhafte Ausgestaltungen, Verbesserungen und weitere Vorteile der Erfindung näher erläutert und beschrieben werden.

Es zeigen:
- **Fig. 1**: eine beispielhafte Anordnung zur Leiter- und Klemmenanordnung in einem Stromzähler, und
- **Fig. 2**: eine weitere beispielhafte Anordnung zur Leiter- und Klemmenanordnung in einem Stromzähler.

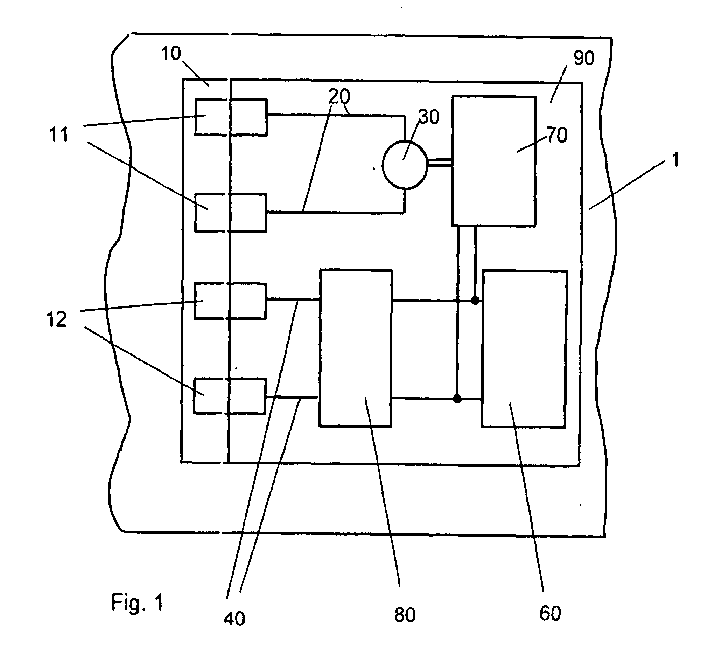

**Fig. 1** zeigt eine beispielhafte Leiter- und Klemmenanordnung in einem Stromzähler, mit in einem Zähiergehäuse 1 angeordneten Messelementen 30 sowie einer Mess signalverarbeitungs- und Anzeigeeinheit 70, wobei das Zählergehäuse 1 zur elektrischen Verbindung des Stromzählers mit dem Stromnetz von der Außenseite des Zählergehäuses 1 zugängliche auf einer Klemmleiste 10 angeordnete Stromanschlussklemmen 11 und Spannungsanschlussklemmen 12 aufweist und jeweils wenigstens eine elektrische Verbindung zur Stromführung 20 zwischen den Stromanschlussklemmen 11 und den Messelementen 30 zur Bestimmung der Stromstärke durch dem Stromzähler nachgeschaltete Verbraucher vorgesehen ist.

Die Messelemente 30 und die Stromanschlussklemmen 11 sind auf einer Platine 90, welche als Leiterplatte ausgeführt ist, aufgelötet und die wenigstens eine Verbindung 20 zur Stromführung zwischen den Stromanschlussklemmen 11 und den Messelementen 30 ist als gedruckte Schaltung oder Leiterbahn auf der Leiterplatte 90 aufgebracht.

Zwischen den Spannungsanschlussklemmen 12 und einem Netzteil 60 zur Energieversorgung des Stromzählers ist wenigstens eine weitere elektrische Verbindung 40 zur Spannungsführung zwischen den Spannungsanschlussklemmen 12 und dem Netzteil 60 zur Energieversorgung des Stromzählers vorgesehen, welche gleichfalls direkt auf der Leiterplatte 90 als gedruckte Schaltung oder Leiterbahn aufgebracht ist.

Alternativ zu einer separat angeordneten Spannungsklemme 12 kann der Spannungsabgriff auch an einer, in diesem Fall auch spannungsführenden, Stromanschlussklemme 11 erfolgen.

In einer vorteilhaften Weiterbildung der erfindungsgemäßen Anordnung sind auf der Leiterplatte 90 auch weitere Baugruppen, wie beispielsweise Überspannungsbegrenzer 80 und das Netzteil 60 zur Energieversorgung des Stromzählers angeordnet.

Optional ist vorgesehen, die mit hohen Strömen oder Spannungen beaufschlagten weiteren Baugruppen 60, 80 des Stromzählers zur Vermeidung von Störeinflüssen getrennt von den Strommesselementen 30 und der Messsignalverarbeitungs- und Anzeigeeinheit 70 auf einem separaten Platinenteil anzuordnen

Somit wird erreicht, dass die die Messsignalverarbeitungs- und Anzeigeeinheit 70 umfassende eigentliche Hauptplatine des Stromzählers völlig frei von hohen Spannungen oder Strömen ist, wodurch in vorteilhafter Weise ein wesentlich optimierterer Aufbau und eine höhere Packungsdichte auf der eigentlichen Hauptplatine erreichbar ist.

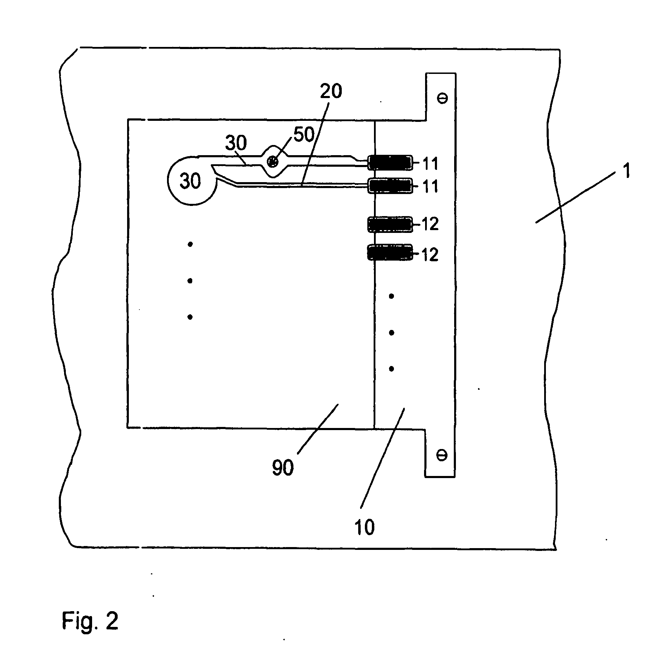

Fig. 2 zeigt eine weitere beispielhafte Leiter- und Klemmenanordnung in einem Stromzähler, wobei die Messelemente 30 als Stromshunts in die Verbindungen zur Stromführung 20 integriert sind oder die Verbindungen zur Stromführung 20 selbst die Messelemente 30 bilden, und die Messelemente 30 unter Ausnutzung des spezifischen ohmschen Widerstandes der, vorzugsweise als Leiterbahn ausgeführten Verbindungen 20 zur Stromführung, die Messung der Stromstärke der dem Stromzähler nachgeschalteten Verbraucher ausführen.

Die sich durch die Verwendung der zur Stromführung vorgesehenen Leiterbahn 20 als Messelement 30 ergebenden Messfehler durch den Temperaturkoeffizienten des spezifischen Widerstandes der Leiterbahn 20, werden in vorteilhafter Weise von einem die Messsignalverarbeitung ausführenden Mikrorechner kompensiert. Dazu ist direkt auf die Leiterbahn 20 zur Stromführung ein Temperaturmessfühler 50 zur Ermittlung des Temperaturkoeffizienten des spezifischen Widerstandes der Leiterbahn 20 integriert, welcher das den Messfehler charakterisierende Signal der Messsignalverarbeitung zur Fehlerkompensation im Mikrorechner zur Verfügung stellt.

Alternativ zur Nutzung des Temperaturkoeffizienten des Temperaturmessfühler 50 ist die Ausnutzung eines weiteren thermischen Effektes der Leiterbahn 20 vorgesehen, der sich beispielsweise aus der Bestimmung der thermoelektrischen Spannung an einem auf der Leiterbahn 20 vorgesehenen Materialübergang ergibt. Das am Materialübergang erzeugte Temperatursignal wird dem die Messsignalverarbeitung ausführenden Mikrorechner zugeführt, der das Temperatursignal so verarbeitet, dass eine Kompensation des Messfehlers stattfindet.

### Bezugszeichenliste

- 1: Zählergehäuse
- 10: Klemmleiste
- 11: Stromanschlussklemme
- 12: Spannungsanschlussklemme
- 20: Verbindung zur Stromführung
- 30: Messelement
- 40: Verbindung zur Spannungsführung
- 50: Temperaturmessfühler
- 60: Energieversorgungseinheit
- 70: Messsignalverarbeitungs- und Anzeigeeinheit
- 80: Überspannungsbegrenzer
- 90: Platine, Leiterplatte

## Patentansprüche

1. Stromzähler mit in einem Zählergehäuse (1) angeordneten Messelementen (30) zur Bestimmung des Leistungsbezuges der dem Stromzähler nachgeschalteten Verbraucher sowie einer Messsignalverarbeitungs- und Anzeigeeinheit (70), einer Energieversorgungseinheit (60) und einem Überspannungsbegrenzer (80), wobei das Zählergehäuse (1) zur elektrischen Verbindung des Stromzählers mit dem Stromnetz von der Außenseite des Zählergehäuses (1) zugängliche Anschlussklemmen (11) aufweist und jeweils wenigstens eine elektrische Verbindung (20) zur Stromführung zwischen den Anschlussklemmen (11) und den Messelementen (30) zur Messung der Stromstärke der dem Stromzähler nachgeschalteten Verbraucher vorgesehen ist, **dadurch gekennzeichnet, dass**
- die Messelemente (30), die Messsignalverarbeitungs- und Anzeigeeinheit (70) und die Anschlussklemmen (11) auf einer Platine (90) angeordnet sind,
- die wenigstens eine Verbindung (20) zur Stromführung als Leiterbahn oder gedruckte Schaltung auf der Platine (90) aufgebracht ist,
- die von der Außenseite des Zählergehäuses (1) zugänglichen Anschlussklemmen (11, 12) auf einer Klemmleiste (10) angeordnet sind, und die Messelemente (30) so in die Verbindung (20) zur Stromführung integriert sind, dass die Messelemente (30) unter Ausnutzung des spezifischen ohmschen Widerstandes der Verbindung (20) die Messung der Stromstärke der dem Stromzähler nachgeschalteten Verbraucher ausführen.

2. Anordnung nach Anspruch 1, **dadurch gekennzeichnet, dass** wenigstens eine weitere elektrische Verbindung zur Spannungsführung (40) zwischen den Anschlussklemmen (12) und einer Einheit zur Energieversorgung des Stromzählers (60) vorgesehen ist, welche direkt auf der Platine (90) als Leiterbahn oder gedruckte Schaltung aufgebracht ist.

3. Anordnung nach Anspruch 1 oder 2, **dadurch gekennzeichnet, dass** die Verbindung (20) zur Stromführung selbst die Messelemente (30) bilden, und die Messelemente (30) unter Ausnutzung des spezifischen ohmschen Widerstandes der Verbindung (20) zur Stromführung, die Messung der Stromstärke der dem Stromzähler nachgeschalteten Verbraucher ausführt.

4. Anordnung nach einem der vorstehenden Ansprüche, **dadurch gekennzeichnet, dass** zur Kompensation des durch den Temperaturkoeffizienten des spezifischen Widerstandes der Leiterbahn (20) auftretenden Messfehlers ein Temperaturmessfühler (50) direkt auf der Verbindung (20) zur Stromführung integriert ist, welcher das den Messfehler charakterisierende Signal einem zur Messsignalverarbeitung und Messfehlerkompensation vorgesehenen Mikrorechner zuführt.

5. Anordnung nach einem der Ansprüche 1 bis 3, **dadurch gekennzeichnet, dass** zur Kompensation des durch den Temperaturkoeffizienten des spezifischen Widerstandes der Leiterbahn (20) auftretenden Messfehlers die thermoelektrische Spannung an einem auf der Verbindung (20) vorgesehenen Materialübergang bestimmbar ist und einem zur Messsignalverarbeitung und die Messfehlerkompensation vorgesehenen Mikrorechner zuführbar ist.

6. Anordnung nach einem der vorherigen Ansprüche **dadurch gekennzeichnet, dass** auf der Platine (90) die mit hohen Strömen oder Spannungen beaufschlagte Baugruppen Energieversorgungseinheit (60) und/oder Überspannungsbegrenzer (80) angeordnet sind.

7. Anordnung nach einem der vorherigen Ansprüche, **dadurch gekennzeichnet, dass** die Platine (90) wenigstens zwei separate Platinenteile umfasst, auf welchen die mit hohen Strömen oder Spannungen beaufschlagte Baugruppen Energieversorgungseinheit (60) und/oder Überspannungsbegrenzer (80) von den Messelementen (30) und der Messsignalverarbeitungs- und Anzeigeeinheit (70) zur Vermeidung von Störeinflüssen getrennt platziert sind.

8. Anordnung nach einem der vorherigen Ansprüche, **dadurch gekennzeichnet, dass** die Anschlussklemmen (11), (12) und Messelemente (30) direkt auf der Platine (90) aufgelötet oder eingepresst sind.

## Claims

1. Electricity meter with measuring elements which are arranged in a meter housing for the determination of the current amount drawn by the loads connected downstream of the electricity meter as well as a measurement signal processing and display unit (70), a power supply unit (60) and an overvoltage limiter (80), the meter housing having connecting terminals (11), (12), which are accessible from the outside of the meter housing (1), for the purpose of electrically connecting the electricity meter to the mains and at least one electrical connection (20) for current carrying respectively being provided between the connecting terminals (11) and the measuring elements (30) for the purpose of measuring the current intensity of the loads connected downstream of the electricity meter, **characterized in that**
- the measuring elements (30), the measurement signal processing and display unit (70) and the connecting terminals (11) are applied to a printed circuit board (90).
- the at least one connection (20) for current carrying is applied to the printed circuit board as a conductor track or as a printed circuit.
- the connecting terminals which are accessible from the outside of the meter housing (11, 12) are arranged on a strip terminal (10), and the measuring elements are integrated in the current conduction connections in such a way that the measuring elements measure the current intensity of the loads connected downstream of the electricity meter using the specific ohmic resistivity of the current conduction connection (20).

2. Arrangement according to claim 1, **characterized in that** at least one further electrical connection for voltage conduction (40) between the connecting terminals (12) and a unit for the power supply of the electricity meter is provided and which is applied directly to the printed circuit board as a conductor track or as a printed circuit.

3. Arrangement according to claim 1 or 2, **characterized in that** the measuring elements (30) form the current conduction connection (20) itself, and the measuring elements (30) measure the current intensity of the loads connected downstream of the electricity meter using the specific ohmic resistivity of the current conduction connection (20).

4. Arrangement according to one of the preceding claims **characterized in that**, in order to compensate for the measurement error arising as a result of the temperature coefficient of the specific resistivity of the conductor track (20), a temperature sensor (50) is directly integrated in the current conduction connection track (20), said temperature sensor supplying the signal which characterizes the measurement error to a microcomputer provided for the purpose of processing measurement signals and compensating for measurement errors.

5. Arrangement according to one of the claims 1 to 3, **characterized in that**, in order to compensate for the measurement error arising as a result of the temperature coefficient of the specific resistivity of the conductor track (20), the thermoelectric voltage can be determined at a material transition provided on the conductor track (20) and can be supplied to a microcomputer provided for the purpose of processing measurement signals and compensating for measurement errors.

6. Arrangement according to one of the preceding claims, **characterized in that** further subassemblies to which high currents or voltages are applied such as the power supply unit (60) and/or overvoltage limiters (80) are arranged.

7. Arrangement according to one of the preceding claims, **characterized in that** the printed circuit board (90) comprises at least two separate printed circuit board parts on which the subassemblies to which high currents or voltages are applied such as the power supply unit (60) and/or overvoltages limiters (80) are placed such that they are separated from the measuring elements (30) and the measurement signal processing and display unit (70) in order to avoid disturbing influences.

8. Arrangement according to one of the preceding claims, **characterized in that** the connecting terminals (11), (12) and the measuring elements (30) are directly soldered onto or pressed into the printed circuit board (90).

## Revendications

1. Compteur d'électricité, avec des éléments de mesure (30) disposés dans un boîtier de compteur (1) pour déterminer le rapport de puissance des récepteurs montés en aval du compteur d'électricité ainsi qu'une unité d'affichage et de traitement du signal de mesure (70), une unité d'alimentation en puissance (60) et un limiteur de surtensions (80), le boîtier de compteur (1) comportant des bornes de raccordement (11) accessibles pour relier électriquement le compteur d'électricité au secteur depuis le côté extérieur du boîtier de compteur (1) et respectivement au moins une connexion électrique (20) servant à guider le courant étant prévue entre les bornes de raccordement (11) et les éléments de mesure (30) pour mesurer l'intensité du courant du récepteur branché en aval du compteur, **caractérisé en ce que**
- les éléments de mesure (30), l'unité de traitement des signaux de mesure et d'affichage (70) et les bornes de raccordement (11) sont disposés sur une platine (90),
- l'au moins une connexion (20) est placée sur la platine (90) pour le guidage du courant sous forme de piste conductrice ou de circuit imprimé,
- les bornes de raccordement (11, 12) accessibles depuis le côté extérieur du boîtier de compteur (1) sont disposées sur une réglette de connexion (10), et les éléments de mesure (30) sont intégrés dans la connexion (20) pour le guidage du courant de telle sorte que les éléments de mesure (30) effectuent la mesure de l'intensité du courant des récepteurs branchés en aval du compteur en utilisant la résistance ohmique spécifique de la connexion (20).

2. Dispositif selon la revendication 1, **caractérisé en ce qu'**au moins une autre connexion électrique est prévue pour guider la tension (40) entre les bornes de raccordement (12) et une unité, pour alimenter en courant le compteur d'électricité (60), ladite connexion étant directement placée sur la platine (90) sous forme d'une piste conductrice ou d'un circuit imprimé.

3. Dispositif selon la revendication 1 ou 2, **caractérisé en ce que** la connexion (20) servant à guider le courant est formée par les éléments de mesure (30) eux-mêmes et que les éléments de mesure (30) réalisent la mesure de la puissance du courant du récepteur placé en aval du compteur d'électricité en utilisant la résistance ohmique spécifique de la connexion (20) pour guider le courant.

4. Dispositif selon l'une quelconque des revendications précédentes, **caractérisé en ce que** pour compenser l'erreur de mesure se produisant du fait du coefficient de température de la résistance spécifique de la piste conductrice (20), on intègre directement un capteur de mesure de température (50) sur la connexion (20) pour guider le courant, ledit capteur amenant le signal caractérisant l'erreur de mesure à un microcalculateur pour traiter le signal de mesure et compenser l'erreur de mesure.

5. Dispositif selon l'une des revendications 1 à 3, **caractérisé en ce que** pour compenser l'erreur de mesure survenant du fait du coefficient de température de la résistance spécifique de la piste conductrice (20), la tension thermoélectrique peut être déterminée pour une transmission de matière prévue sur la connexion (20) et que le microcalculateur prévu pour le traitement du signal de mesure et la compensation de l'erreur de mesure peut être alimenté en courant.

6. Dispositif selon l'une quelconque des revendications précédentes, **caractérisé en ce que** les groupes modulaires alimentés en tensions ou en courants élevés, tels que l'unité d'alimentation en courant (60) et/ou le limiteur de surtension (80), sont disposés sur la platine (90).

7. Dispositif selon l'une quelconque des revendications précédentes, **caractérisé en ce que** la platine (90) comprend au moins deux parties de platine séparées sur lesquelles les groupes modulaires alimentés en tensions ou en courants élevés, tels que l'unité d'alimentation en courant (60) et/ou le limiteur de surtension (80), sont placés de façon séparée des éléments de mesure (30) et de l'unité d'affichage et de traitement du signal de mesure (70) pour éviter les influences perturbatrices.

8. Dispositif selon l'une quelconque des revendications précédentes, **caractérisé en ce que** les bornes de raccordement (11), (12) et les éléments de mesure (30) sont brasés ou encastrés directement sur la platine (90).
